# EUROPEAN PATENT APPLICATION

(11) **EP 4 502 248 A1**
(43) Date of publication of application: **05.02.2025**
(21) Application number: 23796681.7
(22) Date of filing: 14.04.2023
(51) Int. Cl.: C25D 11/18, C25D 11/24, C25D 11/08, C25D 11/10, C25D 11/30, C25D 11/26, C09K 13/04, H05K 5/04, B44C 1/22

(54) **METHOD FOR IMPLEMENTING STRUCTURAL COLOR, AND ELECTRONIC DEVICE COMPRISING STRUCTURAL COLOR**

(30) Priority: 25.04.2022 KR 20220050795; 02.06.2022 KR 20220067684
(71) Applicant: Samsung Electronics Co., Ltd., Suwon-si, Gyeonggi-do 16677 (KR)
(72) Inventor: SONG, Kyunghwan, Suwon-si Gyeonggi-do 16677 (KR); KIM, Youngchun, Suwon-si Gyeonggi-do 16677 (KR); KIM, Inkyu, Suwon-si Gyeonggi-do 16677 (KR); SON, Kidoc, Suwon-si Gyeonggi-do 16677 (KR); SONG, Yurim, Suwon-si Gyeonggi-do 16677 (KR); LEE, Hyuckki, Suwon-si Gyeonggi-do 16677 (KR); KWON, Yongduk, Suwon-si Gyeonggi-do 16677 (KR); KIM, Goeun, Suwon-si Gyeonggi-do 16677 (KR); KIM, Jongbo, Suwon-si Gyeonggi-do 16677 (KR); PARK, Byounggyu, Suwon-si Gyeonggi-do 16677 (KR); HEO, Sungyoung, Suwon-si Gyeonggi-do 16677 (KR); CHOI, Hyunsuk, Suwon-si Gyeonggi-do 16677 (KR)
(74) Representative: HGF
(86) International application number: PCT/KR2023/005115
(87) International publication number: WO 2023/211032

(57) **Abstract**

According to various embodiments of the present disclosure, a method for implementing a structural color comprises the operations of: forming an oxide layer on at least a part of the surface of a metal substrate; coloring the oxide layer with a specified color, and then sealing same; and etching at least a part of the surface of the oxide layer, wherein the etching operation can comprise an operation of dipping the metal substrate in a mixture solution of phosphoric acid and sulfuric acid. Other various embodiments are possible.

## Description

### [Technical Field]

Embodiments of the disclosure relate to an electronic device and, for example, to a method for implementing structural color on an exterior component and/or an electronic device including the implemented structural color.

### [Background Art]

With the advancement of information and communication technology and semiconductor technology, the distribution and use of various electronic devices are rapidly increasing, and recent electronic devices provide an environment that allows even general users to carry and communicate while on the move. In addition, the electronic devices may output information stored therein as sound or an image. As the degree of integration of electronic devices increases and ultra-high-speed and high-capacity wireless communication are becoming more widespread, a single electronic device, such as a mobile communication terminal, is now equipped with various functions. For example, in addition to communication functions, entertainment functions such as gaming, multimedia functions such as music/video playback, communication and security functions for mobile banking or the like, as well as schedule management and electronic wallet functions, are being integrated into a single electronic device. These electronic devices are being miniaturized to be conveniently carried by users. As the carrying and use of miniaturized or slimmed-down electronic devices such as smartphones have become commonplace, user demands for the exterior design of electronic devices may become more sophisticated and diversified.

As user demands for the exterior design of electronic devices become more sophisticated and diversified, various methods for implementing different colors or shapes are being proposed. For example, to enhance aesthetic, various colors and patterns may be implemented using optical interference effects (e.g., structural color). The optical interference effect may be implemented by forming micro-sized patterns on the surface of a synthetic resin film or an ultraviolet-curable film. A film with micro-patterns may provide a decorative effect on the exterior of the electronic device by being attached to an exterior member such as an injection-molded product or a glass plate.

The above-described information may be provided as background technology for the purpose of aiding in the understanding of the disclosure. No claim or determination is made regarding whether any of the foregoing may be applied as prior art with respect to the disclosure.

### [Detailed Description of the Invention]

### [Technical Problem]

By using metal as a material for exterior components of an electronic device, such as a housing or a front or rear surface plate, it is possible to provide mechanical rigidity to the electronic device while providing a texture or decorative effect different from that of an injection-molded product or a glass plate. However, it may be difficult to implement various visual effects, such as structural color, on the surface of a metal substrate, and when using a synthetic resin film to achieve visual effects, the texture of the metal itself may be degraded.

The embodiments of the disclosure are intended to at least resolve the problems and/or the disadvantages described above and to at least provide the advantages described below, and may provide a method for implementing a structural color on a surface of a metal material and/or an electronic device in which a structural color is implemented in the exterior.

The embodiments of the disclosure may provide a method for implementing a structural color on a surface of a metal material while providing a user with the texture of the metal material in its exterior and/or an electronic device in which a structural color is implemented in the exterior.

The embodiments of the disclosure may provide an electronic device that offers a decorative effect through a combination of the color of an oxide layer on a metal material or its surface and a structural color.

Additional aspects according to various embodiments will be presented in the following detailed description, and in part will be apparent from the description or be understood through embodiments of presented implementations.

### [Technical Solution]

According to an embodiment of the disclosure, a method for implementing a structural color includes forming an oxide layer on at least a portion of a surface of a metal substrate, coloring the oxide layer in a predetermined color and sealing the oxide layer, and etching at least a portion of a surface of the oxide layer. In an embodiment, the etching may include immersing the metal substrate in a mixed solution of phosphoric acid and sulfuric acid.

According to an embodiment of the disclosure, an electronic device includes a housing including a first surface, a second surface facing away from the first surface, and a side structure at least partially enclosing the space between the first surface and the second surface, a display disposed on the first surface, and a rear surface plate disposed on the second surface. In an embodiment, at least one of the side surface structure or the rear surface plate may include a metal substrate having a structural color implemented according to an implementation method described above or described below.

According to various embodiments of the disclosure, an electronic device includes a housing including a first surface, a second surface facing away from the first surface, and a side structure at least partially enclosing the space between the first surface and the second surface, a display disposed on the first surface, and a rear surface plate disposed on the second surface. In an embodiment, at least one of the housing or the rear surface plate may include a metal substrate, an oxide layer formed on a surface of the metal substrate, the oxide layer colored with a predetermined color, and irregularities formed on the surface of the oxide layer. In an embodiment, the irregularities may be configured to reflect, refract, scatter, or diffract light incident from the outside.

### [Advantageous Effects]

According to the embodiments, by etching with a mixed solution, irregularities, for example, grooves arranged with depths of 0.5 µm or less and at intervals of 1.6 µm or less, may be formed on the surface of a metal substrate or the surface of an oxide film, and the irregularities may substantially reflect, refract, scatter, and/or diffract incident light to implement a structural color. For example, the metal material may provide various forms of visual decorative effects without substantially affecting the texture provided by the metal material. According to an embodiment, an electronic device may include an external component made of the metal material, thereby providing a decorative effect using a structural color at least in its exterior. In an embodiment, when the surface or an oxide layer of the metal substrate is colored with a predetermined color, the structural color may provide more diverse visual effects by being combined with the predetermined color. In addition, various effects recognized directly or indirectly through this document may be provided.

### [Brief Description of Drawings]

The above-described aspects or other aspects, configurations, and/or advantages regarding various embodiments of the disclosure may become more apparent through the following detailed description made with reference to the accompanying drawings.
FIG. 1 is a flowchart illustrating a method for implementing a structural color according to an embodiment of the disclosure.
FIG. 2 is a view illustrating a metal substrate processed through the operation of forming the oxide layer of FIG. 1.
FIG. 3 is a view illustrating a metal substrate processed through the coloring operation of FIG. 1.
FIG. 4 is a view illustrating a metal substrate processed through the sealing operation of FIG. 1.
FIG. 5 is a view illustrating a metal substrate processed through the etching operation of FIG. 1.
FIG. 6 is a view schematically illustrating a cross-section of a metal substrate processed by the method of FIG. 1.
FIG. 7 is a block diagram illustrating an electronic device according to an embodiment of the disclosure within a network environment.
FIG. 8 is a front perspective view of an electronic device according to an embodiment of the disclosure.
FIG. 9 is a perspective view illustrating the rear surface of the electronic device illustrated in FIG. 8.
FIG. 10 is an exploded perspective view illustrating the electronic device illustrated in FIG. 8;

Throughout the appended drawings, like reference numerals may be assigned to like components, configurations, and/or structures.

### [Mode for Carrying out the Invention]

The following description with reference to the appended drawings may provide an understanding of various exemplary implementations of the disclosure, including the claims and their equivalents. An exemplary embodiment disclosed in the following description includes various specific details to help understanding, but is considered to be one of various exemplary embodiments. Accordingly, it will be apparent to those skilled in the art that various changes and modifications of the various implementations described herein can be made without departing from the scope and spirit of the disclosure. In addition, descriptions of well-known functions and configurations may be omitted for clarity and brevity.

The terms and words used in the following description and claims are not limited to bibliographic meanings, but may be used to clearly and consistently describe various embodiments of the disclosure. Accordingly, it will be apparent to those skilled in the art that the following description of various implementations of the disclosure is provided for illustrative purposes and not intended to limit the scope of the disclosure and its equivalents.

Unless the context clearly indicates otherwise, the singular forms of "a", "an", and "the" should be understood to include the plural meaning. Accordingly, for example, the term "a component surface" may be understood to include one or more surfaces of the component.

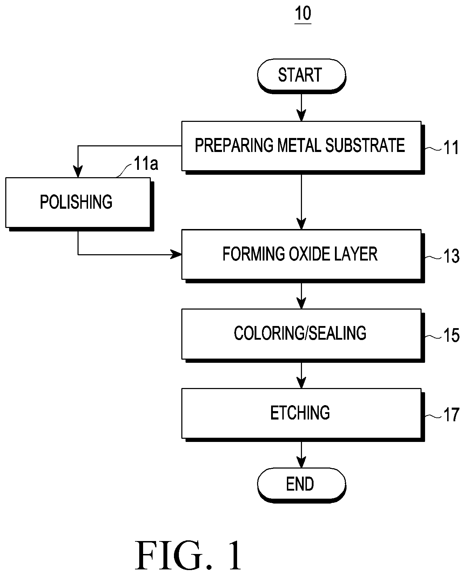

FIG. 1 is a flowchart illustrating a method for implementing a structural color according to an embodiment of the disclosure.

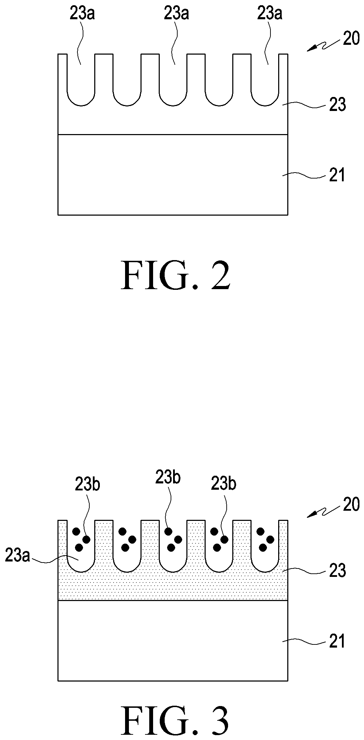

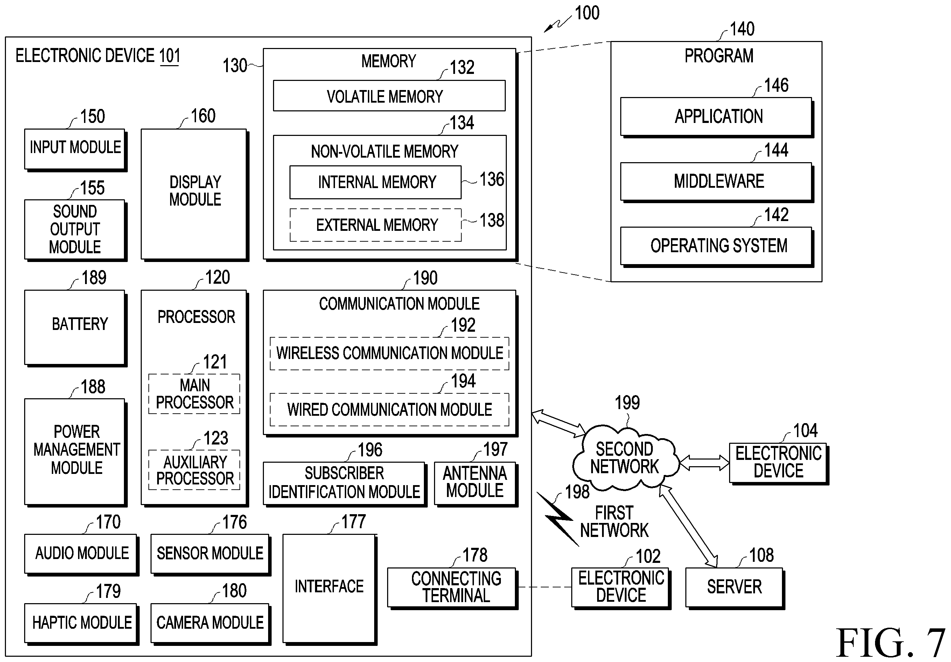

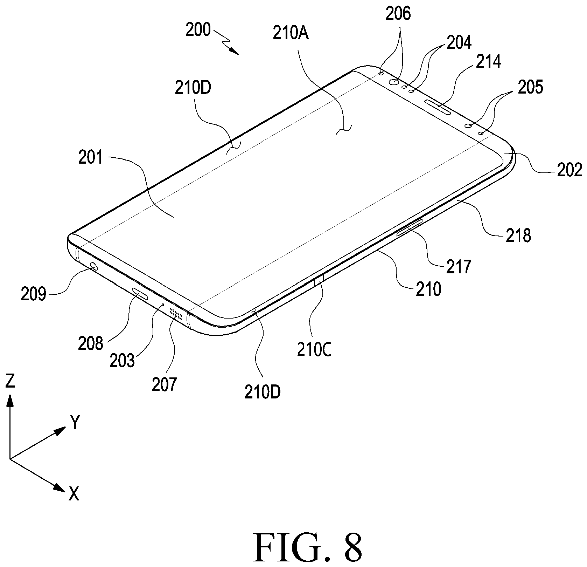

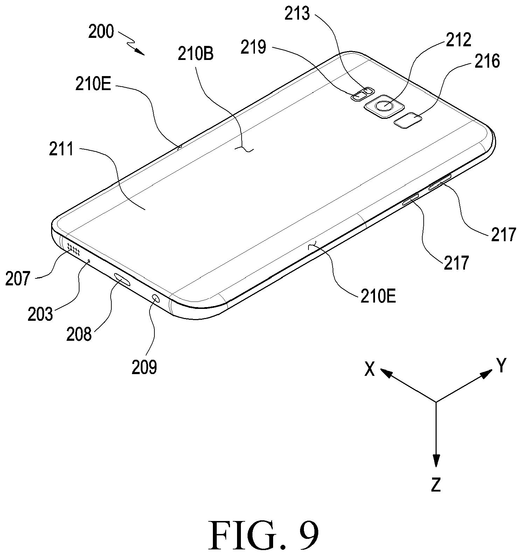

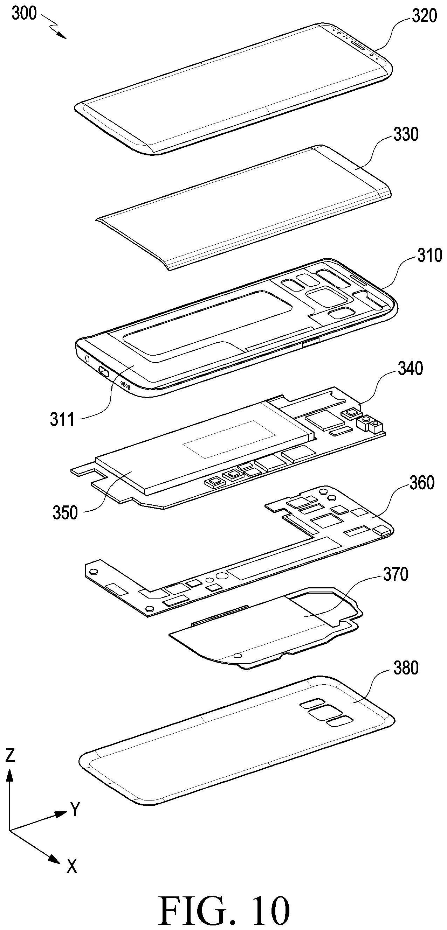

Referring to FIG. 1, the method for implementing a structural color (10) may include an operation of forming an oxide layer (e.g., the oxide layer 23 in FIGS. 2 to 6) on a surface of a metal substrate (e.g., the metal substrate 21 of FIGS. 2 to 5) (13), an operation of coloring and then sealing the oxide layer 23 (15), and/or an operation of etching (17), and may further include an operation of polishing the surface of the metal substrate 21 before the operation of forming the oxide layer 23 (11a) according to an embodiment. In the illustrated embodiment, an operation of preparing a metal substrate 21 (11) is separately exemplified, but since the structural color is implemented on the surface of the metal substrate 21, the method for implementing the structural color (10) according to an embodiment may not include the operation of preparing the metal substrate 21 (11). The metal substrate 21 may be provided as at least one of a housing (e.g., the housing 210 in FIG. 8), a support member (e.g., the first support member 311 and/or the second support member 360 in FIG. 10), a side surface structure (e.g., the side surface 210c of FIG. 8 or the side surface structure 310 in FIG. 10), and/or a rear surface plate (e.g., the rear surface plate 211 or 380 in FIG. 9 or FIG. 10) of an electronic device (e.g., the electronic device 101, 200, or 300 in FIGS. 7 to 10). In an embodiment, when the structural color is implemented on at least a portion of the surface, the metal substrate 21 may be provided as an exterior component, such as a side surface structure or a rear surface plate.

According to an embodiment, the operation of preparing the metal substrate 21 (11) is an operation of manufacturing a metal material (e.g., aluminum, magnesium, or titanium) into a designed component shape, and may process or manufacture the metal material into the metal substrate 21 having a designed shape through processes such as extrusion, pressing, die casting, and/or cutting (e.g., computer numerical control machining). The metal substrate 21 may be substantially flat, and may include at least a partially curved surface, or may include a hole, a recess, and/or a rib or partition according to specifications and shapes required for an actual product to be manufactured (e.g., the electronic device 200 or 300 in FIGS. 8 to 10).

According to an embodiment, the polishing operation (11a) is a process of increasing the gloss of the surface of the manufactured metal substrate 21, and may reduce the surface roughness of the metal substrate 21 through physical or chemical polishing. In an embodiment, the polishing operation (11a) may be omitted or replaced with a process that increases surface roughness and lowers gloss (e.g., sand blasting). For example, the polishing operation (11a) or a sandblasting process as a process for adjusting the gloss or surface roughness on the surface of the metal substrate 21 may be selectively performed according to the specifications required for the product to be actually manufactured. In an embodiment, the surface roughness adjusted through the polishing operation (11a) or the sandblasting process may be perceived by a user's sense of touch.

According to an embodiment, the operation of forming the oxide layer 23 (13) may form the oxide layer 23 on the surface of the metal substrate 21 as a process for increasing the reliability of the metal substrate 21 or an external component. The oxide layer 23 may increase the durability or reliability of the metal substrate 21, for example, by increasing the strength (e.g., hardness) on the surface of the metal substrate 21 or preventing corrosion of the metal substrate due to an external environment. The operation of forming the oxide layer 23 (13) may be performed by, for example, applying electricity while the metal substrate 21 is immersed in an electrolyte solvent containing at least one of sulfuric acid, oxalic acid, oxalic acid, and/or chromic acid, thereby growing the oxide layer 23 on the surface of the metal substrate 21. The electricity may be applied at a voltage of about 5 to 50 V, and the operation of forming the oxide layer 23 (13) may be performed at about 5 to 30 degrees Celsius for about 10 minutes to about 180 minutes.

FIG. 2 is a view illustrating a metal substrate processed through the operation of forming the oxide layer of FIG. 1.

Referring further to FIG. 2, after the operation of forming the oxide layer 23 (13), the component 20 may include the oxide layer 23 formed on the surface of the metal substrate 21. The oxide layer 23 may include, for example, multiple air pores 23a, and may be easily colored. Here, the term "easy to color" may be understood to mean that it is easier to color the oxide layer 23 than to color the surface of the material or the metal substrate 21 on which the oxide layer 23 is not formed.

Referring again to FIG. 1, the coloring and/or sealing operation (15) is a process of dyeing or coloring the surface of the metal substrate 21, for example, the oxide layer 23, with a predetermined color, and may be understood as a "coloring operation" according to an embodiment. For example, the operation of sealing may be understood as part of a substantially coloring operation or coloring process. According to an embodiment, the coloring operation (15) may include an immersion method or an electrolytic coloring method. The immersion method is a method of implementing color by immersing the metal substrate 21 (e.g., the component 20 in FIG. 2) in a solution to which a dye is added/dissolved and allowing the dye to diffuse or adsorb onto the oxide layer 23, and the electrolytic coloring method may be a method of developing color in a metal salt electrolyte by applying an electric current. In this embodiment, the metal substrate 21 (and/or the oxide layer 23) may be immersed in a solution to which an organic dye is added at a temperature of about 30 to 60 degrees Celsius for about 1 to 10 minutes to color the metal substrate 21, for example, the oxide layer 23. In an embodiment, the organic dye may be added to the solution to have a concentration of about 1 to 10 g/l.

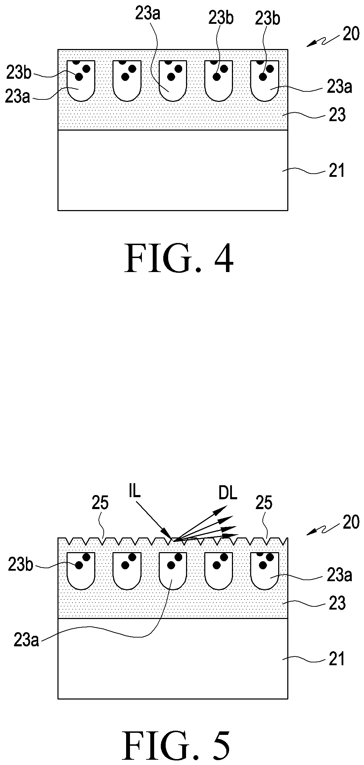

FIG. 3 is a view illustrating a metal substrate processed through the coloring operation of FIG. 1. FIG. 4 is a view illustrating a metal substrate processed through the sealing operation of FIG. 1.

Referring further to FIG. 3, the oxide layer 23 may be colored by the coloring operation (15) or process. For example, organic dye particles 23b may be diffused or adsorbed into the oxide layer 23 or accommodated into the pores 23a, thereby implementing a predetermined color on the surface of the metal substrate 21. In an embodiment, the sealing operation is a process to prevent the detachment of the organic dye particles 23b, and, for example, as illustrated in FIG. 4, the pores 23a may be sealed to substantially maintain the organic dye particles 23b within the oxide layer 23. For example, by performing the sealing operation, discoloration of the metal substrate 21 may be suppressed or prevented.

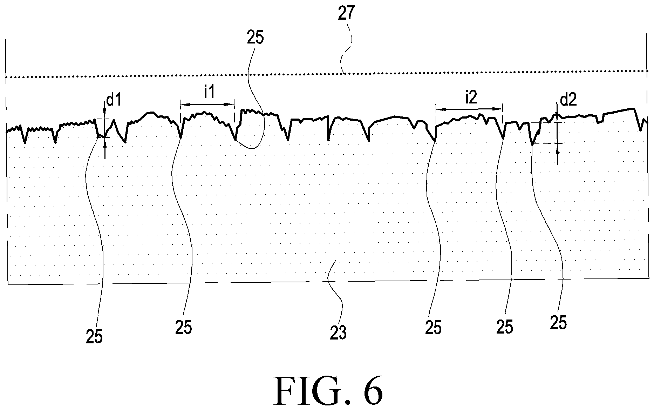

FIG. 5 is a view illustrating a metal substrate processed through the etching operation of FIG. 1. FIG. 6 is a view schematically illustrating a cross-section of a metal substrate processed by the method of FIG. 1.

Referring to FIG. 5 and FIG. 6 together with FIG. 1, the etching operation (17) is an operation of forming recesses 25 on the surface of the metal substrate 21, for example, the surface of the oxide layer 23, using an etching solution, and a structure that generates a structural color (e.g., a roughness or a diffraction grating) may be created by the etching operation (17). For example, in the etching operation (17), grooves 25 having depths d1 and d2 of about 0.5 µm or less may be arranged at intervals i1 and i2 of about 1.6 µm or less, forming an uneven surface on the oxide layer 23, and the grooves 25 or the uneven structure may reflect, refract, scatter, or diffract incident light IL. Depending on various factors such as the behavior of the etching solution or the roughness of the surface of the oxide layer 23, the depths or the intervals between the grooves 25 may be at least partially irregular, and may substantially satisfy the aforementioned numerical values for the depths or intervals. In an embodiment, a structural color may be implemented as the light reflected, refracted, scattered, or diffracted on the surface of the oxide layer 23 (hereinafter, referred to as "diffracted light DL") interfere with each other. In an embodiment, the predetermined color (e.g., a color colored in the oxide layer) and the structural color may be combined to provide a decorative effect on the exterior of the component 20. For example, even when incident from the same path or direction, the diffraction angles of the diffracted light DL may vary depending on the wavelengths of the light. Accordingly, a structural color may be perceived as different colors depending on the angle at which the user views the oxide layer, and may provide various visual effects in combination with the color applied to the oxide layer 23.

According to an embodiment, the etching operation (17) may form irregularities (e.g., the grooves 25 in FIG. 5 or FIG. 6) on the surface of the oxide layer 23 by partially etching the surface of the oxide layer 23 using a mixed acid in which at least two types of acidic solutions are mixed. It may be difficult to create irregularities using only one type of acidic solution. For example, nitric acid may cause discoloration by removing the organic dye, and hydrochloric acid may cause excessive etching of the oxide layer.

In the structural color implementation method according to an embodiment, by using a solution in which about 80 to 95 wt% phosphoric acid and about 5 to 20 wt% sulfuric acid are mixed as an etching solution, an uneven structure in which fine grooves 25 having depths d1 and d2 of about 0.5 µm or less are arranged at dense intervals i1 and i2 of about 1.6 µm or less may be formed. This is because grooves 25 arranged at predetermined intervals i1 and i2 or less may be generated while the surface of the oxide layer 23 is etched by the sulfuric acid component, and the depths d1 and d2 of the grooves 25 may be adjusted by etching by the phosphoric acid component. FIG. 6 is a schematic diagram of an image taken with a scanning electron microscope of a cross-section (e.g., the surface) of the oxide layer 23 after the etching operation (17). As illustrated in FIG. 6, the depths d1 and d2 and arrangement intervals i1 and i2 of the grooves 25 may be dense enough to function substantially as a diffraction grating.

According to an embodiment, the temperature or etching time during etching may be adjusted to suppress excessive etching of the oxide layer 23. For example, the colored and sealed oxide layer 23 (and/or the metal substrate 21) may be immersed in an etching solution (e.g., a mixed acid) to allow the surface of the oxide layer 23 to be partially etched. During the etching, the temperature of the mixed acid may be maintained in the range of about 50 to 70 degrees Celsius, and the oxide layer 23 may be immersed in the etching solution for about 10 to 120 seconds.

According to an embodiment, the metal substrate 21 or the component 20 may further include a coating layer 27 formed to cover the surface of the oxide layer 23 (e.g., the uneven structure or diffraction grating). The coating layer 27 is formed, for example, by applying and curing an ultraviolet-curable resin and is substantially transparent, allowing incident light IL or diffracted light DL to pass through while protecting the uneven structure or diffraction grating from external environments. For instance, the coating layer 27 may suppress damage or wear to the uneven structure. This coating layer 27 may be omitted in some embodiments.

FIG. 7 is a block diagram illustrating an electronic device 101 in a network environment 100 according to various embodiments. Referring to FIG. 7, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to one embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to one embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

In the following detailed description, a length direction, a width direction, and/or a thickness direction of an electronic device may be referred to, wherein the length direction may be defined as the "Y-axis direction", the width direction may be defined as the "X-axis direction", and/or the thickness direction may be defined as the "Z-axis direction". In an embodiment, "negative/positive (-/+)" may be referred to together with the Cartesian coordinate system illustrated in the drawings regarding the directions in which components are oriented. For example, the front surface of an electronic device or a housing may be defined as a "surface oriented in the +Z direction," and the rear surface may be defined as a "surface oriented in the -Z direction", In an embodiment, a side surface of the electronic device or the housing may include an area oriented in the +X direction, an area oriented in the +Y direction, an area oriented in the -X direction, and/or an area oriented in the -Y direction. In an embodiment, the "X-axis direction" may include both the "-X direction" and the "+X direction". It is noted that these are based on the Cartesian coordinate system illustrated in the drawings for the sake of brevity of description, and the description of these directions or components does not limit the various embodiments disclosed herein.

FIG. 8 is a front perspective view of an electronic device 200 according to an embodiment of the disclosure. FIG. 9 is a perspective view illustrating the rear surface of the electronic device 200 illustrated in FIG. 8.

Referring to FIGS. 8 and 9, the electronic device 200 according to an embodiment may include a housing 210 including a first surface (or the front surface) 210A, a second surface (or the rear surface) 210B, and a side surface 210C surrounding the space between the first surface 210A and the second surface 210B. In another embodiment (not illustrated), the housing may refer to a structure defining a part of the first surface 210A, the second surface 210B, and the side surface 210C. According to an embodiment, at least a part of the first surface 210A may be made of a substantially transparent front surface plate 202 (e.g., a glass plate or a polymer plate including various coating layers). The second surface 210B may be made of a substantially opaque rear surface plate 211. The rear surface plate 211 may be made of, for example, coated or colored glass, ceramic, polymer, metal (e.g., aluminum, stainless steel (STS), or magnesium), or a combination of two or more of these materials. The side surface 210C may be formed by the side surface structure 218 including metal and/or polymer and configured to be coupled to the front surface plate 202 and the rear surface plate 211. In an embodiment, the rear surface plate 211 and the side surface structure 218 may be integrated with each other and may include the same material (e.g., a metal material such as aluminum).

In the illustrated embodiment, the front surface plate 202 may include, at the long opposite side edges thereof, two first areas 210D, which are bent from the first surface 210A toward the rear surface plate 211 and extend seamlessly. In the illustrated embodiment (see FIG. 9), the rear surface plate 211 may include, at the long opposite side edges thereof, two second areas 210E, which are bent from the second surface 210B toward the front surface plate 202 and extend seamlessly. In an embodiment, the front surface plate 202 (or the rear surface plate 211) may include only one of the first areas 210D (or the second areas 210E). In another embodiment, some of the first areas 210D or the second areas 210E may not be included. In the above-described embodiments, when viewed from a side of the electronic device 200, the side surface structure 218 may have a first thickness (or width) on the side where the first areas 210D or the second areas 210E are not included, and may have a second thickness, which is smaller than the first thickness, on the side where the first areas 210D or the second areas 210E are included.

According to an embodiment, the electronic device 200 may include at least one of a display 201, audio modules 203, 207, and 214, sensor modules 204, 216, and 219, camera modules 205, 212, and 213, key input devices 217, light-emitting elements 206, and connector holes 208 and 209. In an embodiment, in the electronic device 200, at least one of the components (e.g., the key input devices 217 or the light-emitting element 206) may be omitted, or other components may be additionally included.

The display 201 may be exposed through a substantial portion of, for example, the front surface plate 202. In an embodiment, the display 201 may be at least partially exposed through the front surface plate 202, which defines the first surface 210A and the first areas 210D of the side surface 210C. In an embodiment, the edge of the display 201 may be formed to be substantially the same as the shape of the periphery of the front surface plate 202 adjacent thereto. In another embodiment (not illustrated), the distance between the periphery of the display 201 and the periphery of the front surface plate 202 may be substantially constant in order to enlarge the exposed area of the display 201.

In another embodiment (not illustrated), recesses or openings may be provided in a portion of the screen display area of the display 201, and one or more of the audio modules 214, the sensor modules 204, the camera modules 205, and the light-emitting elements 206, which are aligned with the recesses or the openings, may be included. **In** another embodiment (not illustrated), the rear surface of the screen display area of the display 201 may include at least one of the audio module 214, the sensor modules 204, the camera modules 205, a fingerprint sensor 216, and the light-emitting elements 206. In another embodiment (not illustrated), the display 201 may be coupled to or disposed adjacent to a touch-sensitive circuit, a pressure sensor capable of measuring a touch intensity (pressure), and/or a digitizer configured to detect an electromagnetic field-type stylus pen. In an embodiment, at least some of the sensor modules 204 and 219 and/or at least some of the key input devices 217 may be disposed in the first areas 210D and/or the second areas 210E.

The audio modules 203, 207, and 214 may include a microphone hole 203 and speaker holes 207 and 214. A microphone configured to acquire external sound may be placed inside the microphone hole 203, and in an embodiment, a plurality of microphones may be placed to detect the direction of sound. The speaker holes 207 and 214 may include an external speaker hole 207 and a communication receiver hole 214. In an embodiment, the speaker holes 207 and 214 and the microphone hole 203 may be implemented as a single hole, or a speaker (e.g., a piezo speaker) may be included without the speaker holes 207 and 214.

The sensor modules 204, 216, and 219 may generate electrical signals or data values corresponding to an internal operating state or an external environmental state of the electronic device 200. The sensor modules 204, 216, and 219 may include, for example, a first sensor module 204 (e.g., a proximity sensor) and/or a second sensor module (not illustrated) (e.g., a fingerprint sensor) disposed on the first surface 210A of the housing 210, and/or a third sensor module 219 (e.g., an HRM sensor), and/or a fourth sensor module 216 (e.g., a fingerprint sensor) disposed on the second surface 210B of the housing 210. The fingerprint sensor may be disposed not only on the first surface 210A (e.g., the display 201) of the housing 210, but also on the second surface 210B. The electronic device 200 may further include the sensor module 176 of FIG. 7, for example, at least one of a gesture sensor, a gyro sensor, an atmospheric pressure sensor, a magnetic sensor, an acceleration sensor, a grip sensor, a color sensor, an infrared (IR) sensor, a biometric sensor, a temperature sensor, a humidity sensor, or an illuminance sensor.

The camera modules 205, 212, and 213 may include a first camera device 205 disposed on the first surface 210A of the electronic device 200, and a second camera device 212 and/or a flash 213 disposed on the second surface 210B. The camera devices 205 and 212 may include one or more lenses, an image sensor, and/or an image signal processor. The flash 213 may include, for example, a light-emitting diode or a xenon lamp. In an embodiment, two or more lenses (e.g., an infrared camera lens, a wide-angle lens, and a telephoto lens) and image sensors may be disposed on one surface of the electronic device 200.

The key input devices 217 may be disposed on the side surface 210C of the housing 210. In another embodiment, the electronic device 200 may not include some or all of the above-mentioned key input devices 217, and the key input devices 217, which are not included, may be implemented in another form, such as soft keys, on the display 201. In an embodiment, the key input devices may include a sensor module 216 disposed on the second surface 210B of the housing 210.

The light-emitting elements 206 may be disposed, for example, on the first surface 210A of the housing 210. The light-emitting element 206 may provide, for example, the state information of the electronic device 200 in an optical form. In another embodiment, the light-emitting element 206 may provide a light source that is operationally linked with, for example, the operation of the camera module 205. The light-emitting element 206 may include, for example, an LED, an IR LED, and a xenon lamp.

The connector holes 208 and 209 may include a first connector hole 208 capable of accommodating a connector (e.g., a USB connector) configured to transmit/receive power and/or data to/from an external electronic device, and/or a second connector hole (e.g., an earphone jack) 209 capable of accommodating a connector configured to transmit/receive an audio signal to/from an external electronic device.

FIG. 10 is an exploded perspective view illustrating the electronic device 300 illustrated in FIG. 8.

Referring to FIG. 10, an electronic device 300 may include a side surface structure 310, a first support member 311 (e.g., a bracket), a front plate 320, a display 330, a printed circuit board 340, a battery 350, a second support member 360 (e.g., a rear case), an antenna 370, and a rear plate 380. In an embodiment, in the electronic device 300, at least one of the components (e.g., the first support member 311 or the second support member 360) may be omitted, or other components may be additionally included. At least one of the components of the electronic device 300 may be the same as or similar to at least one of the components of the electronic device 200 of FIG. 8 or FIG. 9, and a redundant description thereof will be omitted below.

The first support member 311 may be arranged inside the electronic device 300 to be connected to the side surface structure 310 or may be integrated with the side surface structure 310. The first support member 311 may be made of, for example, a metal material and/or a non-metal (e.g., polymer) material. The first support member 311 may include one surface to which the display 330 is coupled and the other surface to which the printed circuit board 340 is coupled. A processor, memory, and/or an interface may be mounted on the printed circuit board 340. The processor may include, for example, one or more of a central processing unit, an application processor, a graphics processing unit, an image signal processor, a sensor hub processor, or a communication processor.

The memory may include, for example, volatile memory or non-volatile memory.

The interface may include, for example, a high-definition multimedia interface (HDMI), a universal serial bus (USB) interface, an SD card interface, and/or an audio interface. The interface may electrically or physically connect, for example, the electronic device 300 to an external electronic device, and may include a USB connector, an SD card/MMC connector, or an audio connector.

The battery 350 is a device to supply power to at least one component of the electronic device 300, and may include, for example, a non-rechargeable primary battery, a rechargeable secondary battery, or a fuel cell. At least a portion of the battery 350 may be disposed on substantially the same plane as, for example, the printed circuit board 340. The battery 350 may be integrally disposed inside the electronic device 300, or may be detachably disposed on the electronic device 300.

The antenna 370 may be disposed between the rear surface plate 380 and the battery 350. The antenna 370 may include, for example, a near-field communication (NFC) antenna, a wireless charging antenna, and/or a magnetic secure transmission (MST) antenna. For example, the antenna 370 may execute short-range communication with an external device or may transmit/receive power required for charging to/from an external device in a wireless manner. In another embodiment, an antenna structure may be configured with a portion or a combination of the side surface structure 310 and/or the first support member 311.

According to an embodiment, at least one of a housing (e.g., the housing 210 in FIG. 8), a support member (e.g., the first support member 311 and/or the second support member 360 of FIG. 10), a side surface structure (e.g., the side surface 210c or the side surface structure 218 in FIG. 8 or the side surface structure 310 of FIG. 10), and/or a rear surface plate (e.g., the rear surface plate 211 or 380 of FIG. 9 or FIG. 10) of an electronic device 200 or 300 may at least partially include a metal material. For example, at least a portion of the housing 210, the support member 311 or 360, the side surface structure 310, and the rear surface plate 211 or 380 may include a metal substrate 21 manufactured by the structural color implementation method (10) described with reference to FIGS. 1 to 7. In the illustrated embodiments, the housing 210, the side surface structure 310, and/or the rear surface plate 380 may be at least partially visually exposed from the outside of the electronic device 200 or 300, and at least one of the housing 210, the side surface structure 310, and/or the rear surface plate 380 may include the metal substrate 21 and/or the oxide layer 23 of FIGS. 2 to 6. For example, in the exterior of the electronic device 200 or 300, a color colored in the oxide layer 23 and a structural color implemented by an uneven structure on the surface of the oxide layer 23 may be combined to provide various decorative effects.

In an embodiment, components manufactured by the method (10) of FIG. 1, such as the housing 210, the side surface structure 218 and 310, and/or the rear surface plate 380, may have a color that is a combination of a color colored in the oxide layer 23 and a structural color, even if the area is not exposed to the exterior of the electronic device 200 or 300. In an embodiment, when the side surface structure 218 or 310 is a component manufactured by the method (10) of FIG. 1, and the first support member 311 is integrated with the side surface structure 310, the first support member 310 may have a color that is a combination of a color colored in the oxide layer 23 and a structural color, similar to the side surface structure 310.

As described above, according to the embodiments of the present disclosure, a method for implementing structural color (e.g., the method (10) in FIG. 1) includes an operation of forming an oxide layer (e.g., the oxide layer 23 in FIGS. 2 to 6) on at least a portion of a surface of a metal substrate (e.g., the metal substrate 21 in FIGS. 2 to 5) (e.g., the operation indicated by "13" in FIG. 1), an operation of coloring the oxide layer with a predetermined color and then sealing the oxide layer (e.g., the operation indicated by "15" in FIG. 1), and an operation of etching at least a portion of the surface of the oxide layer (e.g., the operation indicated by "17" in FIG. 1). In an embodiment, the etching operation may include an operation of immersing the metal substrate in a mixed solution of phosphoric acid and sulfuric acid.

According to an embodiment, the mixed solution of phosphoric acid and sulfuric acid may include 80 to 95 wt% phosphoric acid and 5 to 20 wt% sulfuric acid.

According to an embodiment, the etching operation may be performed at a temperature of 50 to 70 degrees Celsius for 10 to 120 seconds.

According to an embodiment, the etching operation may generate irregularities (e.g., grooves 25 in FIG. 5 or FIG. 6), which reflect, refract, scatter, or diffract incident light on the surface of the colored and sealed oxide layer.

According to an embodiment, the etching operation may form grooves having depths of 0.5 µm or less (e.g., the depths indicated by "d1" and "d2" in FIG. 6) at intervals of 1.6 µm or less (e.g., the intervals indicated by "i1" and "i2" in FIG. 6) on the surface of the colored and sealed oxide layer.

According to an embodiment, the method as described above may further include an operation of polishing the surface of the metal substrate (e.g., the operation indicated by "11a" in FIG. 1) prior to forming the oxide layer.

According to an embodiment, the oxide layer forming operation may include applying electricity to the metal substrate immersed in an electrolyte solution containing at least one of sulfuric acid, sodium hydroxide, oxalic acid, or chromic acid.

According to an embodiment, the oxide layer forming operation may be performed by applying electricity at a voltage of 5 to 50 V for 10 to 180 minutes.

According to an embodiment, the oxide layer forming operation may be performed at a temperature of 5 to 30 degrees Celsius.

According to an embodiment, the coloring operation may include immersing the metal substrate in a coloring solution containing an organic dye at a concentration of 1 to 10 g/l for 1 to 10 minutes.

According to an embodiment, the coloring operation may be performed in an environment of 30 to 60 degrees Celsius.

According to an embodiment, the etching operation may include immersing the metal substrate in a mixed solution of 80 to 95% by weight of phosphoric acid and 5 to 20% by weight of sulfuric acid to form, on the surface of the oxide layer, grooves having a depth of 0.5 µm or less and spaced at intervals of 1.6 µm or less.

According to an embodiment, the etching operation may be performed at a temperature of 50 to 70 degrees Celsius for 10 to 120 seconds.

According to an embodiment, the above grooves may be configured to implement a structural color (e.g., see FIG. 5) by reflecting, refracting, scattering, or diffracting incident light on the surface of the oxide layer.

According to an embodiment of the disclosure, an electronic device (e.g., the electronic device 200 or 300 in FIGS. 8 to 10) includes a housing (e.g., the housing 210 in FIG. 8) including a first surface (e.g., the first surface 210A in FIG. 8), a second surface (e.g., the second surface 210B in FIG. 8) facing away from the first surface, and a side surface structure (e.g., the side surface structure 218 or 310 in FIG. 8 or FIG. 10) at least partially surrounding the space between the first surface and the second surface, a display (e.g., the display 201 or 330 in FIG. 8 or FIG. 10) disposed on the first surface, and a rear surface plate (e.g., the rear surface plate 211 or 380 in FIG. 9 or FIG. 10) disposed on the second surface. In an embodiment, at least one of the side surface structure or the rear surface plate may include a metal substrate (e.g., the component 20 or the metal substrate 21 in FIG. 5) having a structural color implemented according to the method described above.

According to an embodiment of the disclosure, an electronic device (e.g., the electronic device 200 or 300 in FIGS. 8 to 10) includes a housing (e.g., the housing 210 in FIG. 8) including a first surface (e.g., the first surface 210A in FIG. 8), a second surface (e.g., the second surface 210B in FIG. 8) facing away from the first surface, and a side surface structure (e.g., the side surface structure 218 or 310 in FIG. 8 or FIG. 10) at least partially surrounding the space between the first surface and the second surface, a display (e.g., the display 201 or 330 in FIG. 8 or FIG. 10) disposed on the first surface, and a rear surface plate (e.g., the rear surface plate 211 or 380 in FIG. 9 or FIG. 10) disposed on the second surface. In an embodiment, at least one of the housing or the rear surface plate includes a metal substrate (e.g., the component 20 or the metal substrate 21 in FIG. 5), an oxide layer formed on a surface of the metal substrate (e.g., the oxide layer 23 in FIG. 5 or FIG. 6), the oxide layer colored in a predetermined color, and irregularities formed on the surface of the oxide layer (e.g., the grooves 25 in FIG. 5 or FIG. 6). In an embodiment, the irregularities may be configured to reflect, refract, scatter or diffract light incident from the outside.

According to an embodiment, the irregularities may include grooves arranged at intervals of 1.6 µm or less (e.g., the intervals indicated by "i1" and "i2" in FIG. 6) while having depths of 0.5 µm or less (e.g., the depths indicated by "d1" and "d2" in FIG. 6).

According to an embodiment, the housing and the rear surface plate may be integrally formed.

According to an embodiment, the oxide layer may be colored with an organic dye.

According to an embodiment, in the exterior of the electronic device as described above, a visual decorative effect may be provided by combining the color of the oxide layer and the structural color generated due to reflected, refracted, scattered, or diffracted light.

According to an embodiment, the irregularities may be formed by etching at least a portion of the surface of the oxide layer with a mixed solution of phosphoric acid and sulfuric acid.

Although the disclosure has been described with reference to various embodiments as an example, it is to be understood that various embodiments are intended to be exemplary and not to limit the disclosure. It will be apparent to those skilled in the art that various changes can be made in form and detail without departing from the overall scope of the disclosure, including the appended claims and equivalents to the same.

## Claims

1. A method for implementing a structural color, the method comprising:
forming an oxide layer on at least a portion of a surface of a metal substrate;
coloring the oxide layer in a predetermined color and sealing the oxide layer; and
etching at least a portion of a surface of the oxide layer,
wherein the etching comprises immersing the metal substrate in a mixed solution of phosphoric acid and sulfuric acid.

2. The method of claim 1, wherein the mixed solution of phosphoric acid and sulfuric acid comprises 80 to 95% by weight of phosphoric acid and 5 to 20% by weight of sulfuric acid.

3. The method of claim 1, wherein the etching is performed for 10 to 120 seconds at a temperature of 50 to 70 degrees Celsius.

4. The method of claim 1, wherein the etching generates irregularities on the surface of the colored and sealed oxide layer that reflect, refract, scatter, or diffract incident light.

5. The method of claim 1, wherein the etching forms grooves on the surface of the colored and sealed oxide layer, the grooves having a depth of 0.5 µm or less and being spaced at intervals of 1.6 µm or less.

6. The method of claim 1, further comprising:
polishing the surface of the metal substrate prior to forming the oxide layer.

7. The method of claim 1, wherein the forming of the oxide layer comprises applying electricity to the metal substrate immersed in an electrolyte solution containing at least one of sulfuric acid, sodium hydroxide, oxalic acid, or chromic acid.

8. The method of claim 7, wherein the forming of the oxide layer is performed by applying electricity at a voltage of 5 to 50 V for 10 to 180 minutes.

9. The method of claim 8, wherein the forming of the oxide layer is performed at a temperature of 5 to 30 degrees Celsius.

10. The method of claim 1, wherein the coloring of the oxide layer comprises immersing the metal substrate in a coloring solution containing an organic dye at a concentration of 1 to 10 g/l for 1 to 10 minutes.

11. The method of claim 10, wherein the coloring of the oxide layer is performed in an environment of 30 to 60 degrees Celsius.

12. The method of claim 1, wherein the etching comprises immersing the metal substrate in a mixed solution of 80 to 95% by weight of phosphoric acid and 5 to 20% by weight of sulfuric acid to form, on the surface of the oxide layer, grooves having a depth of 0.5 µm or less and spaced at intervals of 1.6 µm or less.

13. The method of claim 12, wherein the etching is performed for 10 to 120 seconds at a temperature of 50 to 70 degrees Celsius.

14. The method of claim 12, wherein the grooves are configured to implement a structural color by reflecting, refracting, scattering, or diffracting incident light on the surface of the oxide layer.

15. An electronic device comprising:
a housing comprising a first surface, a second surface facing away from the first surface, and a side surface structure at least partially surrounding a space between the first surface and the second surface;
a display disposed on the first surface; and
a rear surface plate disposed on the second surface,
wherein at least one of the side surface structure or the rear surface plate comprises a metal substrate on which a structural color is implemented according to the method of one of claims 1 to 14.
